# EUROPEAN PATENT APPLICATION

(11) **EP 4 797 934 A1**
(43) Date of publication of application: **26.08.2026**
(21) Application number: 26157727.4
(22) Date of filing: 11.02.2026
(51) Int. Cl.: H10W 40/73, H10W 40/00, H10W 40/20, H10W 20/20, H10W 72/00, H10W 72/90, H10W 90/20, H10D 88/00, H10W 80/00

(54) **HEAT PIPE, SEMICONDUCTOR DEVICE INCLUDING HEAT PIPE, AND METHOD OF MANUFACTURING THEREOF**

(30) Priority: 25.02.2025 US 202563763081 P; 17.09.2025 US 202519331603
(71) Applicant: Samsung Electronics Co., Ltd., Suwon-si, Gyeonggi-do 16677 (KR)
(72) Inventor: MARTINEAU, Jason, San Jose, CA 95134 (US); CHANG, Ho Chan, San Jose, CA 95134 (US)
(74) Representative: Kuhnen & Wacker Patent- und Rechtsanwaltsbüro PartG mbB

(57) **Abstract**

Semiconductor devices and methods of manufacturing the semiconductor devices are provided. For example, a semiconductor device (1) may include: a stack of semiconductor layers including a first semiconductor layer (200B), and a second semiconductor layer (200C) stacked on the first semiconductor layer (200B) in a first direction (Z); a heat sink (300) stacked on the second semiconductor layer (200C) in the first direction (Z); and a heat pipe (100) that extends in the first semiconductor layer (200B), the second semiconductor layer (200C), and the heat sink (300) in the first direction (Z).

## Description

### BACKGROUND

### 1. Field

Embodiments of the present disclosure relate to a heat pipe, a semiconductor device (e.g., a semiconductor package) including the heat pipe, and a method of manufacturing the heat pipe and the semiconductor device.

### 2. Description of Related Art

In stacks of semiconductor dies (e.g., semiconductor chips) of semiconductor packages (e.g., 2.5D+ integrated package), heat buildup between the semiconductor dies may be a limiter of performance of the semiconductor packages. For example, there may be a problem of heat buildup in a center of the semiconductor packages.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

Embodiments of the present disclosure may address the above problems and/or other problems.

According to some example embodiments of the present disclosure, a heat pipe, a semiconductor device (e.g., a semiconductor package) including the heat pipe, and a method of manufacturing the heat pipe and the semiconductor device may be provided.

According to some example embodiments of the present disclosure, a semiconductor device may include: a stack of semiconductor layers including a first semiconductor layer, and a second semiconductor layer stacked on the first semiconductor layer in a first direction; a heat sink stacked on the second semiconductor layer in the first direction; and a heat pipe that extends in the first semiconductor layer, the second semiconductor layer, and the heat sink in the first direction.

According to some example embodiments of the present disclosure, the heat pipe is configured to transfer heat from the stack of semiconductor layers to the heat sink through a working fluid inside the heat pipe.

According to some example embodiments of the present disclosure, the heat pipe is configured to move a working fluid towards the stack of semiconductor layers via capillary action.

According to some example embodiments of the present disclosure, the heat pipe includes: a first via that is inside a via hole of the first semiconductor layer; and a second via that is inside a via hole of the second semiconductor layer, wherein the first via and the second via include an internal space that is configured to move a working fluid through capillary action.

According to some example embodiments of the present disclosure, the semiconductor device further includes: a first via that is inside a via hole of the first semiconductor layer; a second via that is inside a via hole of the second semiconductor layer; and a bonding structure that connects the first semiconductor layer and the second semiconductor layer, wherein the first via and the second via include an internal space that is configured to move a working fluid through capillary action, and wherein the heat pipe is configured to move the working fluid through the bonding structure.

According to some example embodiments of the present disclosure, the semiconductor device further includes: a bonding structure that connects the second semiconductor layer and the heat sink, wherein the bonding structure is non-electrically conductive; and a working fluid in the heat pipe, wherein the working fluid is non-electrically conductive.

According to some example embodiments of the present disclosure, the heat pipe includes: a via in the second semiconductor layer; and a first bonding structure between the first semiconductor layer and the second semiconductor layer; a second bonding structure that connects the second semiconductor layer and the heat sink, wherein the second bonding structure is non-electrically conductive; and a working fluid, wherein the working fluid is non-electrically conductive, wherein an internal space of the via and an internal space of the first bonding structure are configured to move the working fluid via capillary action, and wherein the first semiconductor layer and the second semiconductor layer are electrically connected by the via and the first bonding structure.

According to some example embodiments of the present disclosure, the heat pipe includes: a first via that is inside a via hole of the first semiconductor layer; and a second via that is inside a via hole of the second semiconductor layer, wherein the first via and the second via include an internal space that is configured to move a working fluid through capillary action, wherein the first semiconductor layer is connected to the second semiconductor layer by a bonding structure; and wherein the first via is in fluid communication with the second via through the bonding structure.

According to some example embodiments of the present disclosure, the first semiconductor layer includes a first semiconductor chip, and the second semiconductor layer includes a second semiconductor chip.

According to some example embodiments of the present disclosure, the heat pipe includes a condenser for a working fluid, the condenser being at least partially in the heat sink.

According to some example embodiments of the present disclosure, a semiconductor device may include: a stack of semiconductor chips including a first semiconductor chip including a first via that includes a first internal space, and a second semiconductor chip stacked on the first semiconductor chip in a first direction, the second semiconductor chip including a second via that includes a second internal space; and a heat sink stacked on the second semiconductor chip in the first direction, the heat sink including a third internal space, wherein the first internal space, the second internal space, and the third internal space overlap in the first direction, are in fluid communication, and are configured as a heat pipe.

According to some example embodiments of the present disclosure, the heat pipe is configured to transfer heat from the stack of semiconductor chips to the heat sink through a working fluid inside the heat pipe.

According to some example embodiments of the present disclosure, the heat pipe is configured to move a working fluid towards the stack of semiconductor chips via capillary action.

According to some example embodiments of the present disclosure, the semiconductor device further includes: a bonding structure that connects the second semiconductor chip and the heat sink, wherein the bonding structure is non-electrically conductive; and a working fluid, wherein the working fluid is non-electrically conductive.

According to some example embodiments of the present disclosure, the heat pipe further includes: a first bonding structure between the first semiconductor chip and the second semiconductor chip; a second bonding structure that connects the second semiconductor chip and the heat sink, wherein the second bonding structure is non-electrically conductive; and a working fluid, wherein the working fluid is non-electrically conductive, wherein an internal space of the via and an internal space of the first bonding structure are configured to move the working fluid via capillary action, and wherein the first semiconductor chip and the second semiconductor chip are electrically connected by the first via, second via, and the first bonding structure.

According to some example embodiments of the present disclosure, at least a portion of the first internal space or the second internal space is configured as an evaporator for a working fluid.

According to some example embodiments of the present disclosure, at least a portion of the third internal space is configured as a condenser for a working fluid.

According to some example embodiments of the present disclosure, a method of manufacturing a semiconductor device may include: forming a stack of semiconductor layers, the forming including stacking a second semiconductor layer on a first semiconductor layer in a first direction, wherein the first semiconductor layer includes a first via including a first internal space, and the second semiconductor layer includes a second via including a second internal space; and connecting a heat sink to the second semiconductor layer in the first direction, wherein the heat sink includes a third internal space, wherein the first internal space, the second internal space, and the third internal space overlap in the first direction, are in fluid communication, and are configured as a heat pipe.

According to some example embodiments of the present disclosure, the heat pipe is configured to transfer heat from the stack of semiconductor layers to the heat sink through a working fluid inside the heat pipe.

According to some example embodiments of the present disclosure, the heat pipe is configured to move a working fluid towards the stack of semiconductor layers via capillary action.

### BRIEF DESCRIPTION OF DRAWINGS

Example embodiments of the present disclosure will be more clearly understood from the following detailed description taken in conjunction with the accompanying drawings in which:
FIG. 1 illustrates a schematic perspective view showing a heat pipe according to an example embodiment of the present disclosure;
FIG. 2 illustrates a schematic side view showing the heat pipe of FIG. 1, according to an example embodiment of the present disclosure;
FIG. 3A illustrates a cross-sectional view showing the heat pipe, along a line A-A' of FIG. 2, according to an example embodiment of the present disclosure;
FIG. 3B illustrates a cross-sectional view showing the heat pipe, along a line B-B' of FIG. 2, according to an example embodiment of the present disclosure;
FIG. 3C illustrates a cross-sectional view showing the heat pipe, along a line C-C' of FIG. 2, according to an example embodiment of the present disclosure;
FIG. 4A illustrates a substantially square cross-sectional shape of a heat pipe, according to an example embodiment of the present disclosure;
FIG. 4B illustrates a substantially rectangular cross-sectional shape of a heat pipe, according to an example embodiment of the present disclosure;
FIG. 4C illustrates a substantially rectangular cross-sectional shape of a heat pipe, with curved walls, according to an example embodiment of the present disclosure;
FIG. 5 illustrates a cross-sectional view of a semiconductor device including a heat pipe and a semiconductor layer, according to an example embodiment of the present disclosure;
FIG. 6 illustrates a cross-sectional view of the semiconductor device of FIG. 5 with a plurality of semiconductor layers, according to an example embodiment of the present disclosure; and
FIG. 7 illustrates a flow chart describing a method of manufacturing a semiconductor device including a heat pipe, according to an example embodiment of the present disclosure.

### DETAILED DESCRIPTION

Embodiments of the present disclosure described herein are example embodiments, and thus, the present disclosure is not limited thereto, and may be realized in various other forms. Each of the embodiments provided in the following description is not excluded from being associated with one or more features of another embodiment also provided herein or not provided herein but consistent with the present disclosure. For example, even if matters described in a specific example embodiment are not described in a different example embodiment, the matters may be understood as being related to or combined with the different example embodiment, unless otherwise mentioned in descriptions thereof. In addition, it should be understood that all descriptions of principles, aspects, examples, and embodiments of the present disclosure are intended to encompass structural and functional equivalents thereof. In addition, these equivalents should be understood as including not only currently well-known equivalents but also equivalents to be developed in the future, that is, all devices that perform the same functions regardless of the structures thereof.

It will be understood that when an element, component, layer, pattern, structure, region, or so on (hereinafter collectively "element") of a semiconductor device (or semiconductor package) is referred to as being "on," "connected to," or "coupled to" another element the semiconductor device, it can be directly on, connected to, or coupled to the other element or an intervening element(s) may be present. In contrast, when an element of a semiconductor device is referred to as being "directly on," "directly connected to," or "directly coupled to" another element of the semiconductor device, there are no intervening elements present. Like numerals refer to like elements throughout the present disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions here below, the "left" element and the "right" element may also be referred to as a "first" element or a "second" element, respectively, as long as their structural relationship is clearly understood in the context of the descriptions. Similarly, the terms a "lower" element and an "upper" element may be respectively referred to as a "first" element and a "second" element to distinguish the two elements.

It will be understood that, although the terms "first," "second," "third," "fourth," "fifth," "sixth," etc., may be used herein to describe various elements, these elements should not be limited by these terms. These terms are only used to distinguish one element from another element. Thus, a first element discussed below could be termed a second element without departing from the scope of the present disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" or "equal" is used to compare a dimension of two or more elements, the term may cover a "substantially same" or "substantially equal" dimension.

It will be also understood that, when a method of manufacturing an apparatus or structure is described as including a plurality of steps or operations, a certain step or operation described as being performed later than another step or operation may be performed prior to or at the same time as the other step or operation unless the other step or operation is described as necessarily being performed prior to the step or operation. Further, the method may include additional steps or operations not mentioned in the description.

Many example embodiments are described herein with reference to cross-sectional views that are schematic illustrations of the embodiments (and intermediate structures). As such, variations from the shapes of the illustrations as a result of, for example, manufacturing techniques and/or tolerances are to be expected. Thus, the embodiments should not be construed as limited to the particular shapes of regions illustrated herein, and are to include deviations in shapes that result from, for example, manufacturing. Various regions illustrated in the figures are schematic in nature and their shapes may not be intended to illustrate the actual shape of a region of a device and are not intended to limit the scope of the present disclosure. Further, in the drawings, the sizes and relative sizes of layers and regions may be exaggerated for clarity.

For the sake of brevity, conventional elements, structures, or layers included in a semiconductor package including a connection pad, an adhesive layer, an isolation layer, a barrier metal pattern, a seed layer, etc. may or may not be described in detail herein. For example, descriptions of certain connection pads of a semiconductor chip connected to solder balls or bumps in a semiconductor package may be omitted herein when these structural elements are not related to certain features of the embodiments. Also, descriptions of materials forming well-known structural elements may be omitted herein when those materials are not relevant to certain features of the embodiments. Herein, the term "connection" between two structures or elements may refer to an electrical connection therebetween. For example, a connection between semiconductor chips, semiconductor packages, and/or semiconductor devices may refer to an electrical connection of a corresponding two or more elements to each other. The terms "coupled" and "connected" may have the same meaning and may be used interchangeably herein. Further, the term "isolation" between two structures or elements pertains to electrical insulation or separation therebetween. For example, isolation of wiring patterns from each other may mean that the wiring patterns are not electrically connected to each other.

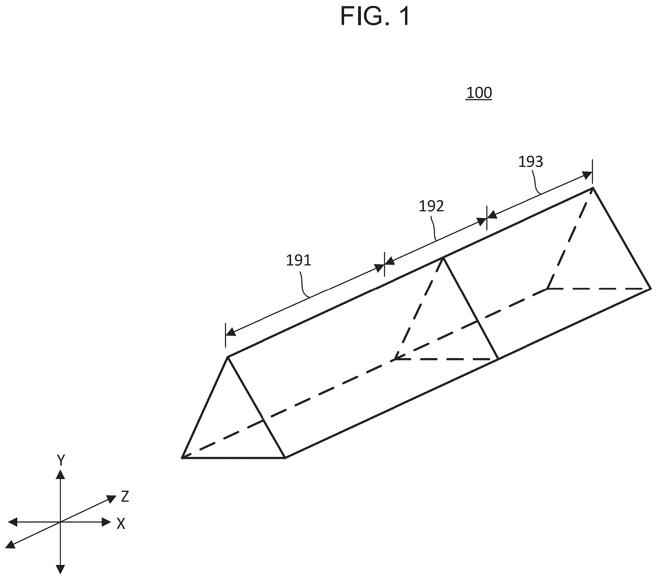

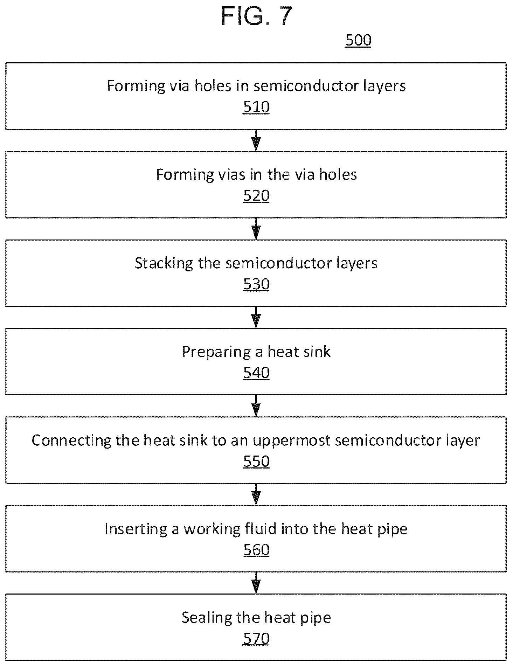

Hereinafter, various example embodiments of the present disclosure are described with reference to FIG. 1, FIG. 2, FIGS. 3A-3C, FIGS. 4A-4C, FIG. 5, FIG. 6 and FIG. 7.

According to example embodiments of the present disclosure, a heat pipe, a semiconductor device (e.g., a semiconductor package) including the heat pipe, and a method of manufacturing the heat pipe and the semiconductor device may be provided.

According to some example embodiments, the heat pipe may be a micro heat pipe.

According to some example embodiments, the heat pipe (e.g., the micro heat pipe) may be implemented, at least in part, by using a through-silicon via(s) (TSV) process. Thus, for example, the heat pipe may be referred to a TSV heat pipe. The TSV heat pipe may be included in a semiconductor device (e.g., a semiconductor package), and may be configured to move heat away from internal layers of the semiconductor device to an outside of the semiconductor device. For example, the TSV heat pipe may be configured to avoid a heat buildup in a portion (e.g., a central portion) of the semiconductor device. For example, the TSV heat pipe may configured to directly remove heat from a center of individual semiconductor dies (e.g., semiconductor chips) and/or from a center of a stack(s) of semiconductor dies (e.g., semiconductor chips).

For example, the TSV heat pipe may be configured to move heat from an intermediate layer(s) of the semiconductor device to an upper (e.g., uppermost) layer(s) of the semiconductor device and/or to a lower (e.g., lowermost) layer(s) of the semiconductor device. Alternatively, the TSV heat pipe may be configured to move heat from the upper (e.g., uppermost) layer(s) of the semiconductor device to the lower (e.g., lowermost) layer(s) of the semiconductor device, or from the lower (e.g., lowermost) layer(s) of the semiconductor device to the upper (e.g., uppermost) layer(s) of the semiconductor device. According to some embodiments, the lower (e.g., lowermost) layer(s), the intermediate layer(s), and/or the upper (e.g., uppermost) layer(s) of the semiconductor device may be or include semiconductor dies (e.g., semiconductor chips). The TSV heat pipe may be provided in and/or vertically through the lower (e.g., lowermost) layer(s), the intermediate layer(s), and/or the upper (e.g., uppermost) layer(s).

According to some embodiments, the lower layer(s), the intermediate layer(s), and/or the upper layer(s) of the semiconductor device may be or include semiconductor dies (e.g., semiconductor chips).

According to some example embodiments, at least one heat pipe (e.g., the TSV heat pipe) may be provided and include a TSV(s) that is hollow and connected to a corresponding hole(s) in a heat sink. For example, the heat sink may be a part of the semiconductor device (e.g., a semiconductor package), and may be, for example, an upper (e.g., uppermost layer) of the semiconductor device and or a lower (e.g., lowermost layer) of the semiconductor device.

According to some example embodiments, the heat pipe (e.g., the TSV heat pipe) may be configured as a vertical heat pipe that extends vertically through one or more stacked semiconductor dies.

According to some example embodiments, the TSV(s) of the heat pipe(s) may be larger than TSVs that are configured to only perform an electrical connection function.

According to some example embodiments, the TSV heat pipe may be configured to perform both a heat transfer function and an electrical connection function. For example, the TSV heat pipe (e.g., the TSV(s) thereof) may be configured to transfer heat of a semiconductor device towards an outside of the semiconductor device, and may be further configured to electrically connect at least two components (e.g., semiconductor dies) of the semiconductor device and/or at least one component (e.g., semiconductor die) of the semiconductor device to at least one component external of the semiconductor device.

According to some example embodiments, the semiconductor device (e.g., the semiconductor package) may be or include a 2.5D+ semiconductor device (e.g., a 2.5D+ semiconductor package). For example, the 2.5D+ semiconductor device may be a 2.5-dimensional (2.5D) semiconductor device (e.g., a 2.5D semiconductor package), a 3-dimensional (3D) semiconductor device (e.g., a 3D semiconductor package), etc.

According to some example embodiments, a semiconductor system may be provided that includes the semiconductor device (e.g., the semiconductor package).

According to some example embodiments, the semiconductor device may include HBM. For example, the TSV heat pipe(s) of the semiconductor device may be configured to transfer heat from a center of individual semiconductor dies (e.g., semiconductor chips) of the HBM and/or from a center of a stack(s) of semiconductor dies (e.g., semiconductor chips) of the HBM to or towards an outside of the semiconductor die(s) or stack(s) of semiconductor dies. For example, the semiconductor dies may be dynamic random-access memory (DRAM) chips.

According to some example embodiments, thermal issues in various configurations of stacked semiconductors dies (e.g., semiconductor chips) may be reduced or avoided.

With reference to FIG. 1, FIG. 2, FIGS. 3A-3C and FIGS. 4A-4C, embodiments of the present disclosure may include a heat pipe 100.

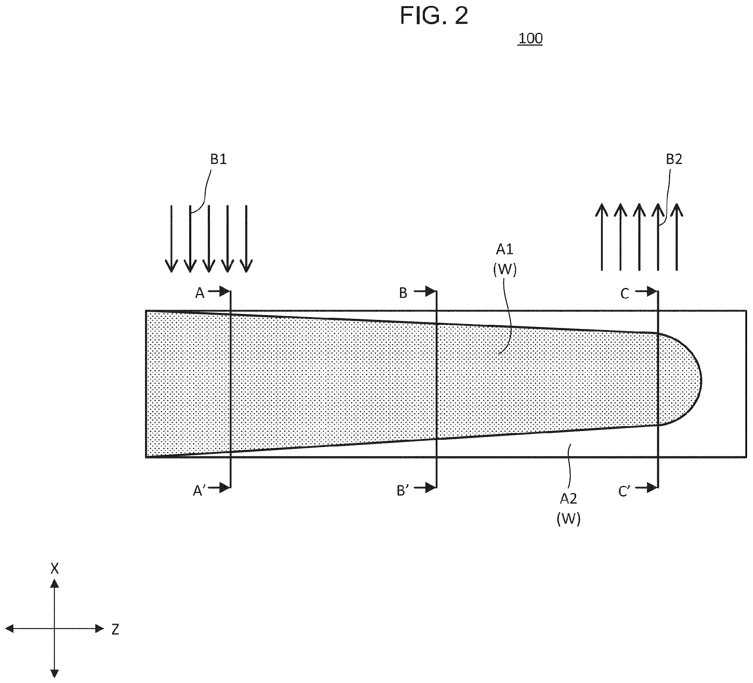

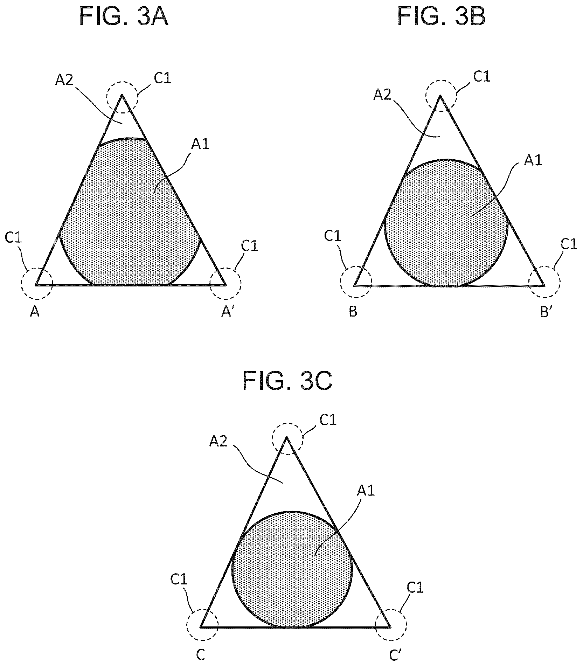

FIG. 1 illustrates a schematic perspective view showing the heat pipe 100 according to an example embodiment of the present disclosure. FIG. 2 illustrates a schematic side view showing the heat pipe 100 of FIG. 1, according to an example embodiment of the present disclosure. FIG. 3A illustrates a cross-sectional view showing the heat pipe 100, along a line A-A' of FIG. 2, according to an example embodiment of the present disclosure. FIG. 3B illustrates a cross-sectional view showing the heat pipe 100, along a line B-B' of FIG. 2, according to an example embodiment of the present disclosure. FIG. 3C illustrates a cross-sectional view showing the heat pipe 100, along a line C-C' of FIG. 2, according to an example embodiment of the present disclosure.

The heat pipe 100 may be a sealed pipe that is configured to transfer heat via the evaporation and condensation of a working fluid W in the heat pipe 100. For example, referring to FIG. 2, a first end of the heat pipe 100 in a first direction (e.g., the Z-direction) may be near (e.g., adjacent) to a heat source and may receive heat B1 from the heat source. The first end of the heat pipe 100 may be referred to as a "hot side" of the heat pipe 100. More particularly, the working fluid W at the first end of the heat pipe 100 may receive the heat B1, and the heat B1 may cause the working fluid W at the first end to evaporate. For example, the working fluid W may become a vapor A1. The vapor A1 may move from the first end of the heat pipe 100 to a second end of the heat pipe 100, opposite to the first end, in the first direction (e.g., the Z-direction). At the second end, the vapor A1 may condense back into a liquid A2, thereby releasing heat B2 from the second end of the heat pipe 100, to an outside of the heat pipe 100. The second end of the heat pipe 100 may be referred to as a "cool side" of the heat pipe 100. After condensing, the liquid A2 may flow back to the first end of the heat pipe 100 via capillary action. According to some embodiments, the process of the working fluid W receiving the heat B1 at the first end of the heat pipe 100, vaporizing, moving to the second end of the heat pipe 100, condensing and releasing the heat B2, and moving back to the first end of the heat pipe 100 via capillary action, may be continuously repeated. Thus, a heat pipe, in comparison to a liquid cooling system, is a closed system requiring no pumping, and relies on a fluid's phase change to transfer the bulk of the heat.

With reference to FIG. 1, the heat pipe 100 may extend in the first direction (e.g., Z-direction), and may include an inner space (e.g., a hole) that includes an evaporator region 191, an adiabatic region 192, and a condenser region 193 that are sequentially arranged in the first direction (e.g., Z-direction). The evaporator region 191 may be a region of the heat pipe 100 in which the working fluid W receives the heat B1 and evaporates. For example, the first end of the heat pipe 100 may at least partially include the evaporator region 191. An example of a cross-section of the evaporator region 191 is shown in FIG. 3A. The adiabatic region 192 may be a region of the heat pipe 100 in between the evaporator region 191 and the condenser region 193, and may be a region by which the working fluid W moves to and from the evaporator region 191 and the condenser region 193. An example of a cross-section of the adiabatic region 192 is shown in FIG. 3B. The condenser region 193 may be a region of the heat pipe 100 in which the working fluid W condenses and releases the heat B2. For example, the second end of the heat pipe 10 may at least partially include the condenser region 193. An example of a cross-section of the condenser region 193 is shown in FIG. 3C.

According to some embodiments, the heat pipe 100 (e.g., the internal space of the heat pipe 100) may have various cross-sectional shapes. For example, the cross-sectional shape of the internal space of the heat pipe 100 may be various closed shapes that includes at least one interior corner C1 configured to cause movement of the working fluid W via capillary action. For example, the at least one interior corner C1 may be respectively configured as a capillary. For example, the interior corner C1 may be defined by two inner surfaces of the heat pipe 100, which at least partially define the inner space of the heat pipe 100. For example, the two inner surfaces may meet at an acute angle. For example, the interior corner C1 may have a sharp, polygonal cross-section.

As a non-limiting example, FIG. 1, FIG. 2 and FIG. 3A-3C show that an inner space of the heat pipe 100 may have a triangular cross-sectional shape, and that the triangular cross-sectional shape may have three interior corners C1 that are configured to cause movement of the working fluid W via capillary action. For example, the working fluid W, as a liquid A2, may move from the condenser region 193, to the adiabatic region 192, and then to the evaporator region 191, through the interior corners C1.

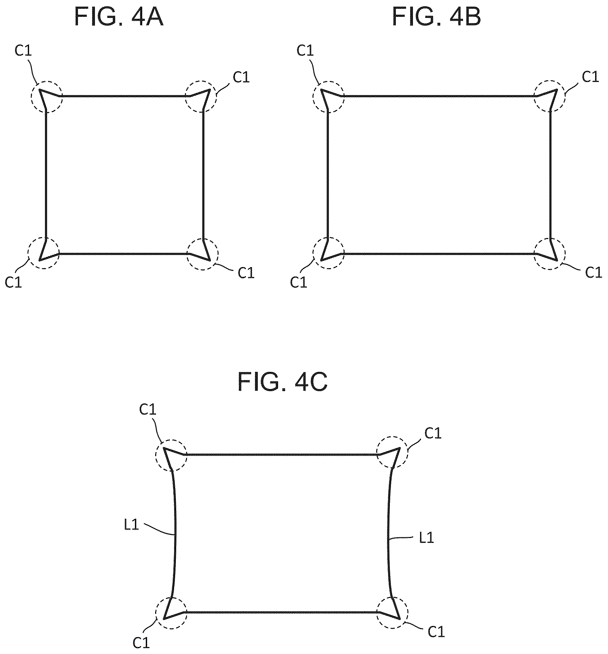

However, embodiments of the present disclosure are not limited thereto. For example, the heat pipe 100, and the internal space thereof, may have various cross-sectional shapes. For example, with reference to FIGS. 4A-4C, the cross-section shapes may include only straight lines (i.e., polygonal) (e.g., FIG. 4A and 4B), or may include a combination of straight and curved lines (e.g., curved lines L1 in FIG. 4C). As non-limiting examples, FIG. 4A illustrates a substantially square cross-sectional shape of the heat pipe 100, and FIGS. 4B and 4C illustrate substantially rectangular cross-sectional shapes of the heat pipe 100. According to some embodiments, the cross-sectional shape of the internal space of the heat pipe 100 may include any number of interior corners C1 configured to cause movement of the working fluid W via capillary action. Additionally, the interior corners C1 may have various shapes. According to some embodiments, a shape and/or size of the cross-section of the internal space of the heat pipe 100 may variously change depending on a position in the first direction (e.g., Z-direction).

According to some embodiments, lengths of the evaporator region 191, the adiabatic region 192, and the condenser region 193 in the first direction (e.g., Z-direction) may be variously provided, and are not limited to the relative lengths shown in FIG. 1.

According to some embodiments, the heat pipe 100 may be a micro heat pipe, and may have various hydraulic diameters. For example, the hydraulic diameter of the heat pipe 100 may be 5 µm. However, embodiments of the present disclosure are not limited thereto. For example, the hydraulic diameter of the heat pipe 100 may be less than or greater than 5 µm. In some embodiments, the hydraulic diameter of the heat pipe 100 may be substantially greater than 5 µm.

According to some embodiments, the working fluid W may be or include de-ionized water (DI water), hydrofluoroether (HFE), or perfluorinated compounds (PFCs) and their derivatives. However, embodiments of the present disclosure are not limited thereto.

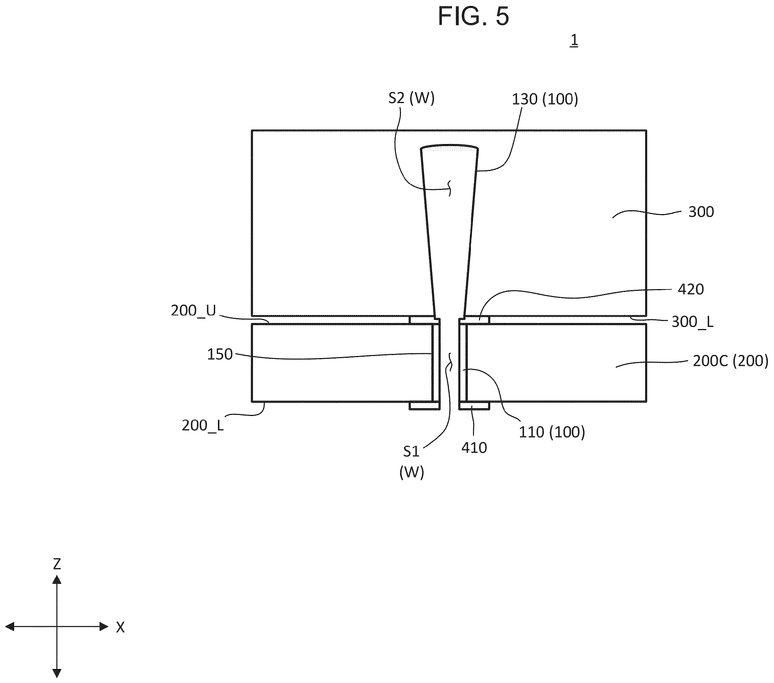

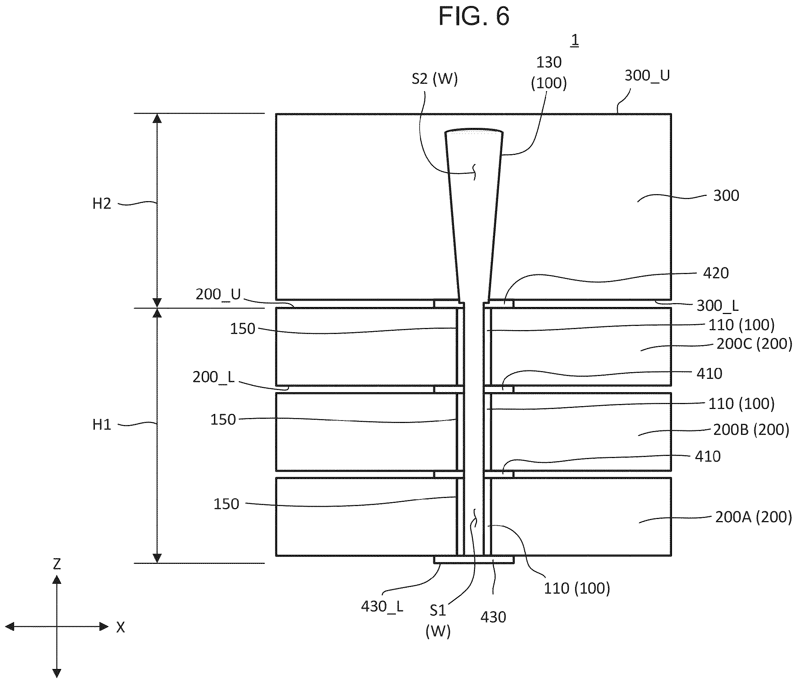

With reference to FIGS. 5-6, a semiconductor device 1 (e.g., semiconductor package) may include the heat pipe 100. FIG. 5 illustrates a cross-sectional view of the semiconductor device 1 according to an example embodiment of the present disclosure. FIG. 6 illustrates a cross-sectional view of an alternative example of semiconductor device 1 with a plurality of semiconductor layers. In FIGS. 5-6, the sizes and relative sizes of layers and regions may be exaggerated for clarity.

According to some embodiments, the semiconductor device 1 may include the heat pipe 100, at least one semiconductor layer 200, and a heat sink 300. The at least one semiconductor layer 200 may be configured to generate heat, for example, as a side product of normal electrical operations conducted therein. The heat pipe 100 may be configured to receive the heat from the at least one semiconductor layer 200 and transfer the heat to the heat sink 300, and the heat sink 300 may be configured to remove the heat from the semiconductor device 1 by, for example, releasing the heat to an external environment of the semiconductor device 1.

According to some embodiments, the at least one semiconductor layer 200 may respectively be a semiconductor die (e.g., a semiconductor chip). For example, each of the at least one semiconductor layer 200 may be or include at least one from among a central processing unit (CPU), a graphics processing unit (GPU), an application-specific integrated circuit (ASIC), a field programmable gate array (FPGA), a memory, etc. According to some embodiments, the at least one semiconductor layer 200 may be a same or different type of semiconductor die (e.g., semiconductor chip) from one another.

According to some embodiments, in a case where a single one of the semiconductor layers 200 is provided as shown in FIG. 5, the first bonding structure 410 may extend horizontally (e.g., in the X-direction or the Y-direction) at (e.g., in or on) the lower surface 200_L of the single semiconductor layer 200 to seal the lower end of a first internal space S1 to be described below.

According to some embodiments, referring to FIG. 6, a plurality of the semiconductor layers 200 may be provided. For example, the plurality of the semiconductor layers 200 may be sequentially stacked in the vertical direction (e.g., Z-direction). For example, the plurality of semiconductors layers 200 may overlap one another in the vertical direction (e.g., Z-direction). However, embodiments of the present disclosure are not limited thereto. For example, a single semiconductor layer 200 may be provided.

According to some embodiments, the heat sink 300 may be on an upper surface 200_U of the at least one semiconductor layer 200, and the heat pipe 100 may be at least partially in or extend through the at least one semiconductor layer 200 and the heat sink 300. For example, the heat pipe 100 may extend vertically (e.g., in the Z-direction) in the at least one semiconductor layer 200 and the heat sink 300.

According to an embodiment, the heat pipe 100 may extend vertically (e.g., in the Z-direction) from a lower surface 200_L of a lower one of the semiconductor layers 200, upwards past the upper surface 200_L of an uppermost one of the semiconductor layers 200 and a lower surface 300_L of the heat sink 300, and to an upper portion of the heat sink 300. For example, with reference to FIG. 6, the heat sink 300 may be provided above (e.g., on) an upper surface 200_U of an uppermost semiconductor layer 200C from among the plurality of semiconductor layers 200, and the heat pipe 100 may extend vertically (e.g., in the Z-direction) from a lower surface 200_L of a lowermost semiconductor layer 200A, from among the semiconductor layers 200, through at least one intermediate semiconductor layer 200B from among the semiconductor layers 200, past the upper surface 200_L of the uppermost semiconductor layer 200C and a lower surface 300_L of the heat sink 300, and to the upper portion of the heat sink 300. However, embodiments of the present disclosure are not limited thereto. For example, a lowermost part of the heat pipe 100 may be defined by an upper surface of a semiconductor layer (e.g., the lowermost semiconductor layer 200A), or within a semiconductor layer (e.g., the lowermost semiconductor layer 200A) such that the lowermost part of the heat pipe 100 is spaced apart from the lower surface of the semiconductor layer.

According to some embodiments, the heat sink 300 may have various configurations for transferring heat. For example, the heat sink 300 may be or include a body including a thermally conductive material. For example, the thermally conductive material may include copper. However, embodiments of the present disclosure are not limited thereto.

According to some embodiments, the heat pipe 100 may include at least one via 110. For example, one or more (e.g., some or all) of the vias 110 may be a through-silicon via (TSV). For example, the via 110 may vertically penetrate a respective semiconductor layer 200 from the lower surface 200_L of the semiconductor layer 200 to the upper surface 200_U of the semiconductor layer 200. For example, the via 110 may be provided in a via hole 150 of the semiconductor layer 200. The via hole 150 may vertically penetrate the semiconductor layer 200 from the lower surface 200_L of the semiconductor layer 200 to the upper surface 200_U of the semiconductor layer 200. According to some embodiments, the via 110 may include an electrically conductive material liner that coats an inner surface of the via hole 150 in horizontal directions (e.g., X-direction or Y-direction). According to such embodiments, the via 110 may be hollow. For example, inner walls of the via 110 may define at least a part of a first inner space S1 in the via 110.

According to some embodiments, the vias 110 may have various cross-sectional shapes, such as the cross-sectional shapes described above with reference to FIG. 1, FIG. 2, FIGS. 3A-3C and FIGS. 4A-4C. However, embodiments of the present disclosure are not-limited thereto.

According to some embodiments, the semiconductor device 1 may further include bonding structures that bond together the semiconductor layers 200 and/or an uppermost one of the semiconductor layers 200 and the heat sink 300. For example, the bonding structures may include at least one first bonding structure 410 between vertically adjacent ones of the semiconductor layers 200, and a second bonding structure 420 between the uppermost one of the semiconductor layers 200 and the heat sink 300. The first bonding structures 410 may connect (e.g., bond) together a respective two of vertically adjacent ones of the semiconductor layers 200. The second bonding structure 420 may connect (e.g., bond) the uppermost one of the semiconductor layers 200 and the heat sink 300.

In some embodiments, the bonding structures (e.g., the first bonding structures 410 and/or the second bonding structure 420) may bond the semiconductor layers 200 at the vias 110 that penetrate them. In some example embodiments, the bonding structures (e.g., the first bonding structures 410 and/or the second bonding structure 420) may have an annular form with a hole propagating therein in the vertical direction, and with the hole having a size and/or cross sectional shape that matches the size and/or cross sectional shape of the vias 110.

According to some embodiments, the first bonding structures 410 may extend horizontally (e.g., in an X-direction or a Y-direction) at (e.g., in or on) a lower surface 200_L or an upper surface 200_U of a semiconductor layer 200. Additionally, the second bonding structure 420 may extend horizontally (e.g., in the X-direction or the Y-direction) at (e.g., in or on) the upper surface 200_U of an uppermost one of the semiconductor layers 200. For example, the second bonding structure 420 may vertically overlap (e.g., in the Z-direction) with the vias 110 and the first bonding structures 410. For example, at least one of the vias 110 may be between (e.g., directly between) and connect (e.g., directly connect) two of the first bonding structures 410. Alternatively or additionally, at least one of the vias 110 may be between (e.g., directly between) and connect (e.g., directly connect) a first bonding structure 410 and the second bonding structure 420. Alternatively or additionally, at least one of the vias 110 may be between (e.g., directly between) and connect (e.g., directly connect) a first bonding structure 410 and a sealing structure 430 to be described below. Alternatively or additionally, at least one of the vias 110 may be between (e.g., directly between) and connect (e.g., directly connect) the second bonding structure 420 and the sealing structure 430.

According to some embodiments, a material of the first bonding structures 410 may be the same as or different from a material of the second bonding structure 420. According to some embodiments, a material of at least one of the first bonding structures 410 may be the same as or different from a material of at least one other of the first bonding structures 410. For example, a material of at least one of the bonding structures (e.g., the first bonding structures 410 or the second bonding structure 420) may be electrically conductive, and a material of at least one other of the bonding structures (e.g., the first bonding structures 410 or the second bonding structure 420) may be electrically non-conductive.

According to some embodiments, with reference to FIG. 6, in a case where N number of semiconductor layers 200 are stacked, N number of vias 110 may be respectively provided in the semiconductor layers 200. Additionally, N-1 first bonding structures 410 may be provided such that respective ones of the first bonding structures 410 are between vertically adjacent ones of the semiconductor layers 200. For example, in the case where three semiconductor layers 200 are stacked, as shown in FIG. 6, one first bonding structure 410 may be provided between the lowermost semiconductor layer 200A and the intermediate semiconductor layer 200B in the vertical direction (e.g., Z-direction), and another first bonding structure 410 may be provided between the intermediate semiconductor layer 200B and the uppermost semiconductor layer 200C in the vertical direction (e.g., Z-direction). The first bonding structures 410 may connect together the vias 110 of the vertically adjacent ones of the semiconductor layers 200. However, embodiments of the present disclosure are not limited thereto. For example, one or more of the semiconductor layers 200 may not include a via 110, and/or a lowermost part of the via 110 in one semiconductor layer 200 may be closed and spaced apart from lower surface of the one semiconductor layer 200, such that the heat pipe 100 does not penetrate through an entirety of the stack of semiconductor layers 200.

According to some embodiments, the first bonding structure 410 and/or the second bonding structure 420 may be various types of bonding structures. For example, the first bonding structure 410 and/or the second bonding structure 420 may be a bonding structure formed through thermal compression bonding (TCB), copper hybrid bonding, etc. According to some embodiments, the first bonding structure 410 and/or the second bonding structure 420 may include copper-to-copper bonding. According to some embodiments, the first bonding structure 410 and/or the second bonding structure 420 may include an electrically conductive material. For example, the electrically conductive material may be copper. However, embodiments of the present disclosure are not limited thereto. For example, the first bonding structure 410 and/or the second bonding structure 420 may be formed through various other bonding processes, and/or may include various materials including electrically conductive or non-conductive materials.

According to some embodiments, one or more (e.g., some or all) of the first bonding structures 410 may include the electrically conductive material, and the second bonding structure 420 may include the electrically non-conductive material. Additionally, the working fluid W may be non-electrically conductive. For example, the second bonding structure 420 may include a non-electrically conductive material such as, for example, Parylene C. For example, the working fluid W may be or include perfluorinated compounds (PFCs) or hydrofluorocarbons (HFCs). According to such embodiments, one or more (e.g., some or all) of the vias 110 may be configured to perform an electrical connection function (e.g., signal or power delivery), in addition to forming a portion of the heat pipe 100. For example, one or more (e.g., some or all) of the semiconductor layers 200 (e.g., semiconductor dies) may be electrically connected to one another through the electrically conductive material liner of the vias 110 and the first conductive bonding structures 410.

According to some embodiments, a through hole or gap may be provided in the first bonding structures 410 such that the hollow spaces of the vias 110, of vertically adjacent ones of the semiconductor layers 200, are in fluid communication with one another. For example, a through hole or gap of the first bonding structures 410 may vertically overlap with one another and the hollow spaces of the vias 110. For example, the through hole or gap of the first bonding structures 410 may define a portion of the first inner space S1.

According to some embodiments, a through hole or gap may be provided in the second bonding structure 420 such that the hollow spaces of the vias 110 are in fluid communication with an internal space S2 of the condenser 130. For example, a through hole or gap of the second bonding structure 420 may vertically overlap with the through hole or gap of the first bonding structures 410 and the hollow spaces of the vias 110.

According to some embodiments, cross-sections of the through hole or gap of the first bonding structures 410 and the second bonding structure 420, and cross-sections of the hollow spaces of the vias 110, may be aligned and have sizes and/or shapes such as to ensure capillary flow of the working fluid W. For example, the cross-sections may be the shapes and/or sizes described above with reference to FIG. 1, FIG. 2, FIGS. 3A-3C and FIGS. 4A-4C. However, embodiments of the present disclosure are not-limited thereto.

According to some embodiments, the combination of the hollow spaces of the vias 110 and the through holes or gaps of the first bonding structures 410 and the second bonding structure 420 may define a single through-hole that extends vertically (e.g., in the Z-direction) through one or more (e.g., some or all) of the semiconductor layers 200. The through-hole may, in part, define the first internal space S1. According to some embodiments, the first internal space S1 may contain a portion of a working fluid W of the heat pipe 100. For example, the via(s) 110, and the first internal space S1 therein, may be a portion of the heat pipe 100 that is configured to receive heat B1 (see FIG. 2). For example, the via(s) 110, and the first internal space S1 therein, may be at least partially configured as the evaporator region 191 (see FIG. 2) of the heat pipe 100, in which the working fluid receives the heat B1 and evaporates. According to some embodiment, at least a portion of the first internal space S1 may be configured as at least a part of the adiabatic region 192 (see FIG. 2) of the heat pipe 100, in which the working fluid moves to and from the evaporator region 191 and the condenser region 193.

According to some embodiment, heat pipe 100 may further include a condenser 130 that is in fluid communication with the first internal space S1. For example, the heat sink 300 may include a hole that extends from the lower surface 300_L of the heat sink 300 to the upper portion of the heat sink 300, such as to define a second internal space S2. For example, the hole in the heat sink 300 may define the condenser 130, and the condenser 130 may include some or all of the second internal space S2. According to some embodiments, at least a portion of the working fluid W may evaporate in a lower portion of the internal space S2, in a case where the lower portion of the internal space S2 is configured as a part of an adiabatic region 192 and/or an evaporator region 191 (see FIG. 1).

According to some embodiments, the cross-sections of the condenser 130 may be aligned with cross-sections of the through hole or gap of the first bonding structures 410 and the second bonding structure 420, and cross-sections of the hollow spaces of the vias 110, and may have sizes and/or shapes such as to ensure capillary flow of the working fluid W. For example, the cross-sections may the shapes and/or sizes described above with reference to FIG. 1, FIG. 2, FIGS. 3A-3C and FIGS. 4A-4C. However, embodiments of the present disclosure are not-limited thereto.

According to some embodiments, the condenser 130, including the second internal space S2, may be a portion of the heat pipe 100 that is configured to release heat B2 (see FIG. 2) to the heat sink 300. For example, the S130 including the second internal space S2, may be at least partially configured as the condenser region 193 of the heat pipe 100, in which the working fluid condenses and releases the heat B2. According to some embodiments, at least a portion of the second internal space S2 may include a part of the adiabatic region 192 (see FIG. 2) of the heat pipe 100, in which the working fluid moves to and from the evaporator region 191 and the condenser region 193.

According to some embodiments, the via holes 150, the hollow spaces of the vias 110 (e.g., the first internal space S1 defined, in part, by the vias 110), and/or the condenser 130 (e.g., the second internal space S2 defined at least in part by the condenser 130) may have various cross-sections such as described above with respect to FIGS. 3A-3C and FIGS. 4A-4C. For example, the shapes of the cross-sections of the via holes 150, the hollow spaces of the vias 110 (e.g., the first internal space S1), and/or the condenser 130 (e.g., the second internal space S2) may include only straight lines (i.e., polygonal), or may include a combination of straight and curved lines. Additionally, the shapes of the cross-sections of the via holes 150, the hollow spaces of the vias 110 (e.g., the first internal space S1), and/or the condenser 130 (e.g., the second internal space S2) may include any number of interior corners C1 (see FIGS. 3A-3C and FIGS. 4A-4C) configured to cause movement of the working fluid W via capillary action in the vertical direction (e.g., Z-direction), and the interior corners C1 may have various shapes.

According to some embodiments, a shape and/or size of the cross-sections of the via holes 150, the hollow spaces of the vias 110 (e.g., the first internal space S1), and/or the condenser 130 (e.g., the second internal space S2) may variously change depending on a position in the vertical direction (e.g., Z-direction). For example, with reference to FIGS. 5-6, a width of the first internal space S1 in a horizontal direction (e.g., X-direction or Y-direction) may remain constant in the vertical direction (e.g., Z-direction), while a width in the horizontal direction (e.g., X-direction or Y-direction) of the second internal space S2 may increase in the vertical direction (e.g., Z-direction). According to some embodiments, at one or more (e.g., some or all) vertical levels of the condenser 130, the width of the second internal space S2 may be larger than the width (e.g., largest width) of the first internal space S1. However, embodiments of the present disclosure are not limited to the shapes, sizes, and widths described above. According to some embodiments, the hollow spaces of the vias 110 may take the shape of the corresponding via hole 150 when the via 110 is formed in the via hole 150.

According to some embodiments, with reference to FIG. 6, a sealing structure 430 may be provided. For example, the sealing structure 430 may include a body that seals a lower end of the first inner space S1. For example, the sealing structure 430 may extend horizontally (e.g., in the X-direction or the Y-direction) at (e.g., in or on) the lower surface 200_L of the lowermost semiconductor layer 200A. The sealing structure 430 may define the lower end of the first internal space S1. For example, the sealing structure 430 may seal the lower end of the heat pipe 100 such as to prevent the working fluid W from escaping the semiconductor device 1 through the lower end. For example, the sealing structure 430 may not include a hole or a through-hole.

According to some embodiments, the sealing structure 430 may be a bonding structure that bonds the lowermost semiconductor layer 200A to another component of the semiconductor device 1. For example, the sealing structure 430 may be a bonding structure formed through thermal compression bonding (TCB), hybrid bonding, etc. According to some embodiments, the sealing structure 430 may include copper-to-copper bonding. According to some embodiments, the sealing structure 430 may include an electrically conductive material. For example, the electrically conductive material may be copper. However, embodiments of the present disclosure are not limited thereto. For example, the sealing structure 430 may be formed through various other bonding processes, and/or may include various materials including electrically conductive or non-conductive materials. Alternatively, the sealing structure 430 may not be a bonding structure.

According to some embodiments, the vias 110, the first bonding structures 410, the second bonding structure 420, and the sealing structure 430 may be connected to one another and may overlap one another in the vertical direction (e.g., Z-direction).

According to some embodiments, by the internal space S1 vertically extending through one or more (e.g., some or all) of the semiconductor layers 200 that generate heat (e.g., heat B1 of FIG. 2), the heat pipe 100 may be configured to receive the heat from the one or more (e.g., some or all) of the semiconductor layers 200. For example, at least a portion of the first internal space S1 may be configured as the evaporator region 191 (see FIG. 1), and the heat may cause the working fluid in the first internal space S1 to evaporate. Additionally, at least a portion of the first internal space S1 and/or the second internal space S2 may be configured as the adiabatic region 192, in which the vapor A1 (see FIG. 2) moves to and from the evaporator region 191 and the condenser region 193, and at least a portion of the second internal space S2 may be configured as the condenser region 193 of the heat pipe 100, in which the working fluid condenses and releases the heat B2 (see FIG. 2) to the heat sink 300. After condensing, the working fluid may return to first internal space S1 via capillary action due to the internal corners (C1) of one or more (e.g., some or all) from among the condenser 130 and the vias 110.

According to some embodiments, a height H1 from a lower surface of the sealing structure 430 to the upper surface 200_U of the uppermost semiconductor layer 200C, or from a lower surface of the lowermost semiconductor layer 200A to the upper surface 200_U of the uppermost semiconductor layer 200C, may be various values. The height H1 may alternatively be the height of the first inner space S1 in some embodiments. As a non-limiting example, the height H1 may be about 1 mm.

According to some embodiments, a height H2 from the upper surface 200_U of the uppermost semiconductor layer 200C to an upper surface 300_U of the heat sink 300 may be various values. The height H2 may alternatively be the height of the condenser 130 in some embodiments. As a non-limiting example, the height H2 may be about 9 mm.

According to some embodiments, referring to FIGS. 5-7, a method 500 of manufacturing a semiconductor device (e.g., the semiconductor device 1), including the heat pipe 100, may be provided.

For example, the method 500 may include forming the via holes 150 in the semiconductor layers 200 (operation 510), forming the vias 110 in the via holes 150 (operation 520), stacking the semiconductor layers 200 (operation 530), preparing the heat sink 300 (operation 540), connecting the heat sink 300 to an uppermost one of the semiconductor layers 200 (operation 550), inserting the working fluid W into the heat pipe 100 (operation 560), and sealing the heat pipe (operation 570).

According to some embodiments, the operation 510 may include etching via holes 150 into one or more of the semiconductor layers 200, respectively. For example, the via hole 150 may be etched such as to vertically penetrate the semiconductor layer 200 from the lower surface 200_L of the semiconductor layer 200 to the upper surface 200_U of the semiconductor layer 200. According to some embodiments, the via holes 150 may be simultaneously etched into the plurality of the semiconductor layers 200, or the via holes 150 may be etched at different times.

According to some embodiments, the operation 520 may include forming the vias 110 by depositing a material into the via holes 150. For example, the operation 520 may include performing thin-layer copper deposition in the via holes 150 to form the vias 110. For example, the material (e.g., copper) of the vias 110 may coat an inner surface of the via hole 150 in horizontal directions (e.g., X-direction or Y-direction) and the vias 110 may be hollow, such as to define a portion of the first inner space S1 of the heat pipe 100 to be formed The deposition of operation 520 may also form pads. For example, the pads may be portions that are used to form the first bonding structure 410 and/or the second bonding structure 420.

According to some embodiments, the operation 530 may include stacking the semiconductor layers 200 in the vertical direction (e.g., Z-direction), and bonding the semiconductor layers 200 by forming the first bonding structures 410. For example, the operation 530 may include vertically aligning (e.g., overlapping) the vias 110 of the semiconductor layers 200. For example, the capillaries (e.g., corners C1) of the hollow spaces of the vias 110 may be vertically aligned (e.g., overlapping) with one another. According to some embodiments, the bonding may include performing thermal compression bonding (TCB) or copper hybrid bonding between the semiconductor layers 200. For example, in an embodiment, the bonding may include performing copper-to-copper bonding, and the first bonding structure 410 may be formed of the copper of the copper-to-copper bonding. According to some embodiments, the semiconductor layers 200 may be vertically aligned and bonded together such that a single through-hole extends vertically (e.g., in the Z-direction) through the semiconductor layers 200, and defines the internal space S1 therethrough.

According to some embodiments, the operation 540 may include forming the condenser 130 in the heat sink 300. For example, the operation 540 may include etching at least one void into the heat sink 300, such that the at least one void defines the condenser 130, including the second internal space S2 of the heat pipe 100 to be formed. For example, the at least one void (and the condenser 130) may include a hole that extends from the lower surface 300_L of the heat sink 300 to the upper portion of the heat sink 300, such as to define the second internal space S2.

According to some embodiments, the operation 550 may include providing the heat sink 300 on the upper surface 200_U of the uppermost semiconductor layer 200C, and bonding the heat sink 300 to the uppermost semiconductor layer 200C. For example, the operation 530 may include vertically aligning (e.g., overlapping) the condenser 130 with the via 110 of the uppermost semiconductor layer 200C. For example, the capillaries (e.g., corners C1) of the condenser 130 and the hollow spaces of the via 110 may be vertically aligned (e.g., overlapping) with one another. According to some embodiments, the bonding may include performing thermal compression bonding (TCB) or hybrid bonding between the uppermost semiconductor layer 200C and the heat sink 300. For example, in an embodiment, the bonding may include performing copper-to-copper bonding, and the second bonding structure 420 may be formed of the copper of the copper-to-copper bonding. Alternatively, the second bonding structure 420 may be formed. According to some embodiments, the heat sink 300 and the uppermost semiconductor layer 200C may be vertically aligned and bonded together such that the first internal space S1 and the second internal space S2 are overlapping with one another in the vertical direction (e.g., Z-direction) and in fluid communication with one another.

According to some embodiments, the operation 560 may include inserting the working fluid W into the first internal space S1 and/or the second internal space S2 of the heat pipe 100. For example, a predetermined amount of the working fluid W may be inserted to have a predetermined pressure. For example, the working fluid W may be inserted into the semiconductor device through the hollow space of the via 110 of the lowermost semiconductor layer 200A. For example, at the time of operation 560, the lower end of the hollow space of the via 110 of the lowermost semiconductor layer 200A may be exposed to an outside of the semiconductor device. According to some embodiments, the operation 560 may be performed before or concurrently with the operation 540 and/or the operation 550.

According to some embodiments, the operation 570 may include sealing the heat pipe 100 with the sealing structure 430. For example, the sealing structure 430 may be provided such as to extend horizontally (e.g., in the X-direction or the Y-direction) at (e.g., in or on) the lower surface 200_L of the lowermost semiconductor layer 200A. The sealing structure 430 may seal a lower end of the first inner space S1, thereby preventing the working fluid W from escaping the semiconductor device 1. According to some embodiments, the operation 560 may include causing the internal space (e.g., the first inner space S1 and the second inner space S2) of the heat pipe 100 to have a vacuum state. For example, the operation 570 may include removing air from the heat pipe 100 via a vacuum. Accordingly, the heat pipe 100 may be sealed in a vacuum state.

According to some embodiments, the providing the sealing structure 430 at (e.g., in or on) the lower surface 200_L of the lowermost semiconductor layer 200A may be provided prior to operations 530, 540, 550, 560, and/or 570. For example, after the sealing structure 430 is provided, the heat sink 300 having the working fluid W therein may be connected to the uppermost semiconductor layer 200C to seal the heat pipe 100 (operations 550-570).

According to some embodiments, in a case where a lowermost part of the heat pipe 100 is within a semiconductor layer (e.g., the lowermost semiconductor layer 200A) such that the lowermost part of the heat pipe 100 is spaced apart from the lower surface of the semiconductor layer, the sealing structure 430 may not be provided. For example, the sealing of the heat pipe 100 (operation 570) may be performed by connecting the heat sink 300 having the working fluid W therein to the uppermost semiconductor layer 200C.

The present disclosure is presented to enable one of ordinary skill in the art to make and use the present disclosure and to incorporate it in the context of particular applications. While the foregoing is directed to specific examples, other and further examples may be devised without departing from the scope of the present disclosure.

Various modifications, as well as a variety of uses in different applications will be readily apparent to those skilled in the art, and the general principles defined herein may be applied to a wide range of embodiments. Thus, the present disclosure is not intended to be limited to the example embodiments presented herein, and is to be accorded the widest scope consistent with the principles and novel features disclosed herein.

In the description provided, numerous specific details are set forth in order to provide a more thorough understanding of the present disclosure. However, it will be apparent to one skilled in the art that the present disclosure may be practiced without necessarily being limited to these specific details. In other instances, well-known structures and devices are shown in block diagram form, rather than in detail, in order to avoid obscuring the present disclosure.

All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Various features are described in the present disclosure with reference to the drawings. It should be noted that the drawings are only intended to facilitate the description of the features. They are not intended as an exhaustive description of the present disclosure or as a limitation on the scope of the present disclosure. In addition, an illustrated example need not have all the aspects or advantages shown. An aspect or an advantage described in conjunction with a particular example is not necessarily limited to that example and can be practiced in any other examples even if not so illustrated, or if not so explicitly described.

The labels "left," "right," "front," "back," "top," "bottom," "forward," "reverse," "clockwise" and "counter clockwise," if used, have been used for convenience purposes only and are not intended to imply any particular fixed direction. Instead, they are used to reflect relative locations and/or directions between various portions of an object.

While embodiments have been described with respect to circuit functions, the embodiments of the present disclosure are not limited. Possible implementations, may be embodied in a single integrated circuit, a multi-chip module, a single card, system-on-a-chip, or a multi-card circuit pack. As would be apparent to one skilled in the art, the various embodiments might also be implemented as part of a larger system. Such embodiments might be employed in conjunction with, for example, a digital signal processor, microcontroller, field-programmable gate array, application-specific integrated circuit, or general-purpose computer.

For the sake of brevity, conventional elements to semiconductor devices may or may not be described in detail herein. However, even if a certain element is described or illustrated in a semiconductor device in the present disclosure, the element may not be included in a claimed semiconductor device unless the element is recited as being included in the claimed semiconductor device. Also, when a particular method for deposition or etching used in manufacturing a semiconductor device is or is not mentioned herein, it will be understood that a conventional method for such deposition or etching may be applied in corresponding steps of manufacturing the semiconductor device.

While non-limiting example embodiments have been described above in connection with the drawings, it will be apparent to those skilled in the art that modifications and variations could be made without departing from the scope of the appended claims.

## Claims

1. A semiconductor device (1) comprising:
a stack of semiconductor layers (200) comprising:
a first semiconductor layer (200B); and
a second semiconductor layer (200C) stacked on the first semiconductor layer (200B) in a first direction (Z);
a heat sink (300) stacked on the second semiconductor layer (200C) in the first direction (Z); and
a heat pipe (100) that extends in the first semiconductor layer (200B), the second semiconductor layer (200C), and the heat sink (300) in the first direction (Z).

2. The semiconductor device (1) of claim 1, wherein the heat pipe (100) is configured to transfer heat from the stack of semiconductor layers (200) to the heat sink (300) through a working fluid (W) inside the heat pipe (100).

3. The semiconductor device (1) of claim 1, wherein the heat pipe (100) is configured to move the working fluid (W) towards the stack of semiconductor layers (200) via capillary action.

4. The semiconductor device (1) of claim 1, wherein the heat pipe (100) comprises:
a first via (110) that is inside a via hole (150) of the first semiconductor layer (200B); and
a second via (110) that is inside a via hole (150) of the second semiconductor layer (200C),
wherein the first via (110) and the second via (110) comprise an internal space (S1) that is configured to move a working fluid (W) through capillary action.

5. The semiconductor device (1) of claim 1, further comprising:
a first via (110) that is inside a via hole (150) of the first semiconductor layer (200B);
a second via (110) that is inside a via hole (150) of the second semiconductor layer (200C); and
a bonding structure that connects the first semiconductor layer (200B) and the second semiconductor layer (200C),
wherein the first via and the second via comprise an internal space that is configured to move a working fluid (W) through capillary action, and
wherein the heat pipe (100) is configured to move the working fluid (W) through the bonding structure.

6. The semiconductor device (1) of claim 1, further comprising:
a bonding structure that connects the second semiconductor layer (200C) and the heat sink (300), wherein the bonding structure is non-electrically conductive; and
a working fluid (W) in the heat pipe (100), wherein the working fluid (W) is non-electrically conductive.

7. The semiconductor device (1) of claim 1, wherein the heat pipe (100) comprises:
a via (110) in the second semiconductor layer (200C);
a first bonding structure (410) between the first semiconductor layer (200B) and the second semiconductor layer (200C);
a second bonding structure (420) that connects the second semiconductor layer (200C) and the heat sink (300), wherein the second bonding structure (420) is non-electrically conductive; and
a working fluid (W), wherein the working fluid (W) is non-electrically conductive,
wherein an internal space of the via (110) and an internal space (S1) of the first bonding structure (410) are configured to move the working fluid (W) via capillary action, and
wherein the first semiconductor layer (200B) and the second semiconductor layer (200C) are electrically connected by the via (110) and the first bonding structure (410).

8. The semiconductor device (1) of claim 1, wherein the heat pipe (100) comprises:
a first via (110) that is inside a via hole (150) of the first semiconductor layer (200B); and
a second via (110) that is inside a via hole (150) of the second semiconductor layer (200C),
wherein the first via (110) and the second via (110) comprise an internal space (S1) that is configured to move a working fluid (W) through capillary action,
wherein the first semiconductor layer (200B) is connected to the second semiconductor layer (200C) by a bonding structure (410); and
wherein the first via (110) is in fluid communication with the second via (110) through the bonding structure (410).

9. The semiconductor device (1) of any one of the preceding claims, wherein the first semiconductor layer (200B) comprises a first semiconductor chip, and the second semiconductor layer (200C) comprises a second semiconductor chip.

10. The semiconductor device (1) of any one of the preceding claims, wherein the heat pipe (100) comprises a condenser (130) for a working fluid (W), the condenser (130) being at least partially in the heat sink (300).

11. The semiconductor device (1) according to claim 1, wherein:
the stack of semiconductor layers (200) comprises a stack of semiconductor chips comprising:
a first semiconductor chip comprising a first via (110) that comprises a first internal space; and
a second semiconductor chip stacked on the first semiconductor chip in a first direction (Z), the second semiconductor chip comprising a second via (110) that comprises a second internal space; and
the heat sink (300) is stacked on the second semiconductor chip in the first direction (Z), the heat sink (300) comprising a third internal space (S2),
the first internal space, the second internal space, and the third internal space (S2) overlap in the first direction (Z), are in fluid communication, and are configured as a heat pipe (100).

12. The semiconductor device (1) of claim 11, wherein the heat pipe (100) is configured to transfer heat from the stack of semiconductor chips to the heat sink (300) through a working fluid (W) inside the heat pipe (100).

13. The semiconductor device (1) of claim 11, wherein the heat pipe (100) is configured to move a working fluid (W) towards the stack of semiconductor chips via capillary action.

14. The semiconductor device (1) of claim 11, further comprising:
a bonding structure (420) that connects the second semiconductor chip and the heat sink (300), wherein the bonding structure (420) is non-electrically conductive; and
a working fluid (W), wherein the working fluid (W) is non-electrically conductive.

15. The semiconductor device (1) of claim 11, wherein the heat pipe (100) further comprises:
a first bonding structure (410) between the first semiconductor chip and the second semiconductor chip;
a second bonding structure (420) that connects the second semiconductor chip and the heat sink (300), wherein the second bonding structure (420) is non-electrically conductive; and
a working fluid (W), wherein the working fluid (W) is non-electrically conductive,
wherein the first internal space of the first via (110), the second internal space of the second via (110) and an internal space of the first bonding structure (410) are configured to move the working fluid (W) via capillary action, and
wherein the first semiconductor chip and the second semiconductor chip are electrically connected by the first via (110), the second via (110), and the first bonding structure (410).
